Europäisches Patentamt

European Patent Office

Office européen des brevets

(11) Veröffentlichungsnummer: **0 321 801 B1**

(12) **EUROPÄISCHE PATENTSCHRIFT**

(45) Veröffentlichungstag der Patentschrift: **01.04.92**

(21) Anmeldenummer: **88120593.4**

(22) Anmeldetag: **09.12.88**

(51) Int. Cl.⁵: **H03K 17/08**, H01L 29/72, H03K 17/10, H01L 27/06

(54) **Abschaltbarer Thyristor mit Überspannungsschutz.**

(30) Priorität: **23.12.87 CH 5014/87**

(43) Veröffentlichungstag der Anmeldung: **28.06.89 Patentblatt 89/26**

(45) Bekanntmachung des Hinweises auf die Patenterteilung: **01.04.92 Patentblatt 92/14**

(84) Benannte Vertragsstaaten: **CH DE FR GB IT LI NL SE**

(56) Entgegenhaltungen:
**EP-A- 0 224 757**
**DE-A- 3 425 414**
**DE-A- 3 537 419**

**O: KILGENSTEIN "Formeln und Diagramme der Elektronik - Diskrete Halbleiterbauelemente" 1. Auflage 1981, VOGEL-VERLAG, Würzburg, Seiten 241, 242**

**SCR MANUAL SIXTH EDITION, GENERAL ELECTRIC COMPANY, 1979, Auburn, New York, Seiten 159, 160**

**J. MARKUS "Modern Electronic Circuits Rer- ference Manual", 1980, McGRAW-HILL BOOK COMPANY, Seite 1130**

(73) Patentinhaber: **BBC Brown Boveri Aktienge- sellschaft**

**CH-5401 Baden(CH)**

(72) Erfinder: **Grüning, Horst, Dr. Im Ergel 10 CH-5404 Baden(CH)**

## Beschreibung

TECHNISCHES GEBIET

Die vorliegende Erfindung bezieht sich auf das Gebiet der Leistungshalbleiter. Sie betrifft speziell einen abschaltbaren Thyristor mit Überspannungsschutz, insbesondere für den Einsatz in einer Serieschaltung mehrerer Thyristoren, welcher abschaltbare Thyristor eine Anode, eine Kathode und ein Gate aufweist.

STAND DER TECHNIK

Während bei den verhältnismässig kleinen Strömen, die mit IGTs (Insulated Gate Transistors) und Leistungs-MOSFETs geschaltet werden, Betriebsspannungen über 1000 V selten sind, arbeiten herkömmliche Thyristoren und abschaltbare Thyristoren (z.B. GTO-Thyristoren) oft in Netzen mit weit höherer Spannung (einige 10 bis einige 100 kV).

Die Thyristoren werden deshalb in Serie geschaltet. Dies ist möglich, weil man die notwendige gleichmässige Aufteilung der Gesamtspannung auf die einzelnen Elemente durch gleichzeitiges Zünden und eine geeignete Zusatzbeschaltung beherrschen kann.

Eine derartige Zusatzbeschaltung für herkömmliche Thyristoren ist beispielsweise aus dem SCR Manual, 5th Edition (1972) von der Firma General Electric, S. 165 - 159, bekannt. Sie kann einerseits als sogenannte "Snubber"-Beschaltung aus passiven Elementen wie Widerständen und Kondensatoren ausgeführt sein (dortige Fig. 6.7).

Sie kann andererseits aber auch aktive Elemente wie Varistoren oder Avalanchedioden umfassen (Fig. 6.9), die oberhalb einer kritischen Spannung leitend werden und damit einen aktiven Überspannungsschutz darstellen.

Weiterhin ist es auch bekannt (EP-A2-0 209 986), bei einem herkömmlichen Thyristor mit "amplifying gate" innerhalb des Substrats als Überspannungsschutz eine Avalanchezone vorzusehen, die bei einer kritischen Spannung durchsteuert und den Thyristorteil über sein Gate einschaltet. Nachteilig ist hier jedoch, dass der Thyristor selbst zum Überspannungsabbau verwendet wird, also kein vom Thyristor unabhängiger Schutzmechanismus existiert.

Während sich bei den herkömmlichen, nicht abschaltbaren Thyristoren der beschriebene Ueberspannungsschutz bewährt hat, treten bei abschaltbaren Thyristoren (GTO-Thyristoren und FCThs = Field Controlled Thyristors) neue Probleme auf.

GTOs und FCThs sollen mit verhältnismässig hoher Frequenz arbeiten. Ihr Ausschaltzeitpunkt hängt wegen der für diese Thyristoren spezifischen Speicherzeit stark von der Ansteuerung ab. Gleichzeitig streut die Grösse der Speicherladung bei den einzelnen Elementen mindestens genauso stark wie bei herkömmlichen Thyristoren. Das hat zur Folge, dass eine entsprechende Snubber-Beschaltung leistungsmässig sehr stark ausgelegt werden müsste, was zu einer unverhältnismässig grossen Verlustleistung führen würde.

Aus diesem Grunde kommt bei abschaltbaren Thyristoren nur ein aktiver Überspannungsschutz in Form eines Ableiters (Varistor oder Avalanchediode) in Frage. Trotz der kurzen Schaltzeiten speziell von FCThs müssen solche Ableiter für recht hohe Leistungen ausgelegt sein: Bei 4 kV Klemmspannung, 1000 A Abschaltstrom, 2 kHz Wiederholfrequenz und 0,3 Mikrosekunden Belastung des Ableiters pro Periode ergibt sich eine Verlustleistung von 2,4 kW pro Ableiter.

Avalanchedioden für solche Belastungen sind aber nicht bekannt. Auch ZnO-Varistoren können wegen ihrer geringen Wärmeleitfähigkeit (der Keramik) nicht weit über 200 W Leistung abführen, wobei die Kapselung und Kühlung solcher Elemente etwa gleich aufwendig ist, wie diejenige von Hochleitungsthyristoren.

Aus dem Buch von O. Kilgenstein, "Formeln und Diagramme der Elektronik - Diskrete Halbleiterbauelemente", 1.Auflage 1981, VOGEL-VERLAG, Würzburg, Seiten 241-242, insbesondere dem dortigen Bild 3.1.7.25 ist es bekannt, einem bipolaren Transistor als Überspannungsschutz beim Abschalten induktiver Lasten eine leistungsstarke Z-Dioden-Nachbildung aus einer Z-Diode und einem bipolaren Leistungstransistor parallel zu schalten. Die direkte Übertragung einer solchen Lösung auf einen abschaltbaren Thyristor würde jedoch zu einer entsprechend aufwendigen Beschaltung aus mehreren diskreten Bauelementen führen.

DARSTELLUNG DER ERFINDUNG

Aufgabe der vorliegenden Erfindung ist es nun, einen abschaltbaren Thyristor mit Überspannungsschutz zu schaffen, der vergleichsweise wenig zusätzlichen Aufwand erfordert und mit bekannten Mittel realisiert werden kann. Die Aufgabe wird bei einem abschaltbaren Thyristor der eingangs genannten Art dadurch gelöst, dass

(a) der Überspannungsschutz einen J-FET sowie einen Ueberspannungssensor umfasst; wobei

    (aa) der J-FET mit seinem Drain an die Anode und mit seiner Source an die Kathode des abschaltbaren Thyristors angeschlossen ist; und

    (bb) der Überspannungssensor zwischen Drain und Gate des J-FET angeordnet ist;

(b) der abschaltbare Thyristor ein feldgesteuerter Thyristor FCTh ist; und

(c) der FCTh und der J-FET auf einem gemeinsamen Substrat nebeneinander integriert sind; wobei

(aa) der FCTh zwischen der Anode und der Kathode eine Schichtenfolge aus einer $p^+$-dotierten Anodenzone, einer $n^-$-dotierten Kanalschicht, einer p-dotierten Gatezone und $n^+$-dotierten Kathodenbereichen umfasst, wobei die Kathodenbereiche auf der Oberseite von durch Gräben getrennten Steuerfingern angeordnet sind, die Kanalschicht in den Steuerfingern bis zu den Kathodenbereichen reicht, und die Gatezone in die Böden und Wände der Gräben eingelassen ist;

(bb) der J-FET zwischen dem Drain und der Source eine Schichtenfolge aus einer $n^+$-dotierten Drainzone, einer $n^-$-dotierten Kanalschicht, einer p-dotierten Gatezone und $n^+$-dotierten Sourcebereichen umfasst, wobei die Sourcebereiche auf der Oberseite von durch Gräben getrennten Steuerfingern angeordnet sind, die Kanalschicht in den Steuerfingern bis zu den Sourcebereichen reicht, und die Gatezone in die Böden und Wände der Gräben eingelassen ist;

(cc) beim FCTh über den Kathodenbereichen Kathodenkontakte, auf den Grabenböden Gatekontakte, und auf der Anodenzone ein Anodenkontakt angebracht sind; und

(dd) beim J-FET über den Sourcebereichen Sourcekontakte, auf den Grabenböden Gatekontakte, und auf der Drainzone ein Drainkontakt angebracht sind.

Der Kern der Erfindung besteht also darin, für Überspannungsdetektion und Spannungsbegrenzung nicht ein einziges hochbelastbares Bauelement einzusetzen, sondern die Überspannungsdetektion mit einem Überspannungssensor geringerer Belastbarkeit durchzuführen und mit diesem Sensor einen höher belastbaren regelbaren Widerstand anzusteuern, der den Erfordernissen optimal angepasst werden kann. Dabei ist der abschaltbare Thyristor ein FCTh, der steuerbare Widerstand ein J-FET, und beide sind auf einem gemeinsamen Substrat nebeneinander integriert.

Hierdurch wird ein äusserst kompaktes Bauelement realisiert, das bezüglich Gehäuse und Kühlung für den Überspannungsschutz keinen zusätzlichen Aufwand erfordert.

Gemäss einem bevorzugten Ausführungsform der Erfindung ist der Überspannungssensor eine Avalanchediode, die auch noch in das Substrat integriert werden kann.

Weitere Ausführungsbeispiele ergeben sich aus den abhängigen Ansprüchen.

KURZE BESCHREIBUNG DER ZEICHNUNG

Die Erfindung soll nachfolgend anhand von Ausführungsbeispielen im Zusammenhang mit der Zeichnung näher erläutert werden. Es zeigen:

Fig. 1A-C    verschieden Möglichkeiten der passiven und aktiven Überspannungsbegrenzung bei herkömmlichen Thyristoren nach dem Stand der Technik;

Fig. 2    die Prinzipschaltung eines J-FET-Ueberspannungsschutzes für einen abschaltbaren Thyristor;

Fig. 3A    eine vollständige Thyristorstufe mit Thyristorkaskade und Überspannungsschutz;

Fig. 3B    eine Fig. 3A entsprechende Thyristorstufe mit zusätzlicher Verstärkung zwischen dem Überspannungssensor und dem regelbaren Widerstand; und

Fig. 4    das Ausführungsbeispiel eines FCTh mit integriertem J-FET und integrierter Avalanchediode.

WEGE ZUR AUSFÜHRUNG DER ERFINDUNG

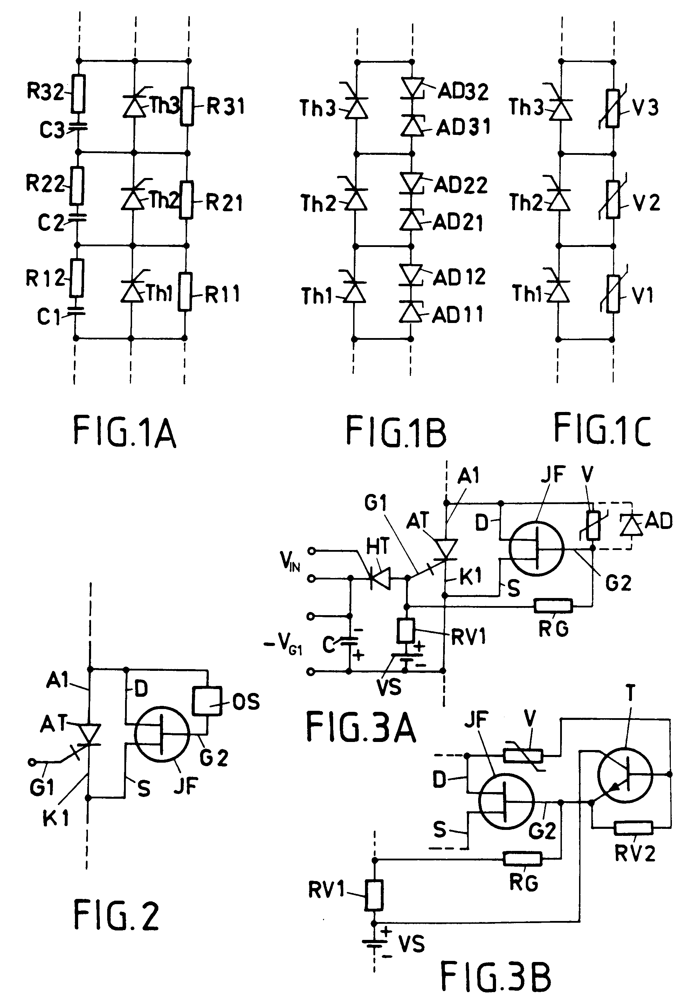

In den Fig. 1A-C sind verschiedene Arten des Überspannungsschutzes für herkömmliche Thyristoren in Serieschaltung dargestellt, wie sie aus dem Stand der Technik bekannt sind.

Fig. 1A zeigt speziell eine passive Snubber-Beschaltung, bei der jedem der Thyristoren Th1, ..., Th3 Kombinationen aus Widerständen R11, ..., R32 und Kondensatoren C1, ..., C3 parallelgeschaltet sind.

Fig. 1B zeigt eine erste Variante eines aktiven Überspannungsschutzes, bei der jedem der Thyristoren Th1, ..., Th3 ein Paar von entgegengesetzt angeordneten Avalanchedioden AD11, 12 bzw. AD21, 22 bzw. AD31, 32 parallelgeschaltet ist.

Fig. 1C schliesslich zeigt eine zweite Variante eines aktiven Überspannungsschutzes, bei dem anstelle der Avalanchedioden AD11, ..., AD32 Varistoren V1, ..., V3 vorgesehen sind.

Wie bereits eingangs erwähnt, können diese bekannten Überspannungsschutz-Beschaltungen bei herkömmlichen Thyristoren ohne Probleme realisiert werden, weil dort wegen der relativ geringen Schaltfrequenzen sehr viel weniger Verlustleistung anfällt.

Bei abschaltbaren Thyristoren (GTO-Thyristoren und FCThs) mit ihren höheren Betriebsfrequenzen geht die Erfindung einen vollkommen anderen Weg: Dem abschaltbaren Thyristor AT wird zwischen seiner Anode A1 und seiner Kathode K1 ein steuerbarer Widerstand parallelgeschaltet (Fig. 2), der von einem Überspannungssensor OS angesteuert wird.

Der Überspannungssensor OS detektiert den Überspannungszustand am abschaltbaren Thyristor AT und steuert dann den steuerbaren Widerstand so, dass die Ueberspannung über ihn abgebaut wird.

Im Ausführungsbeispiel der Fig. 2 ist der steuerbare Widerstand ein J-FET (JF), dessen Source S mit der Kathode K1 und dessen Drain D mit der Anode A1 des abschaltbaren Thyristors AT verbunden ist.

Da hier, anders als bei den Avalanchedioden und Varistoren aus Fig. 1B, C, Sensorfunktion und Ableitfunktion von getrennten Schaltungsteilen wahrgenommen werden, kann der steuerbare Widerstand optimal für die abzuführende Verlustleistung ausgelegt werden.

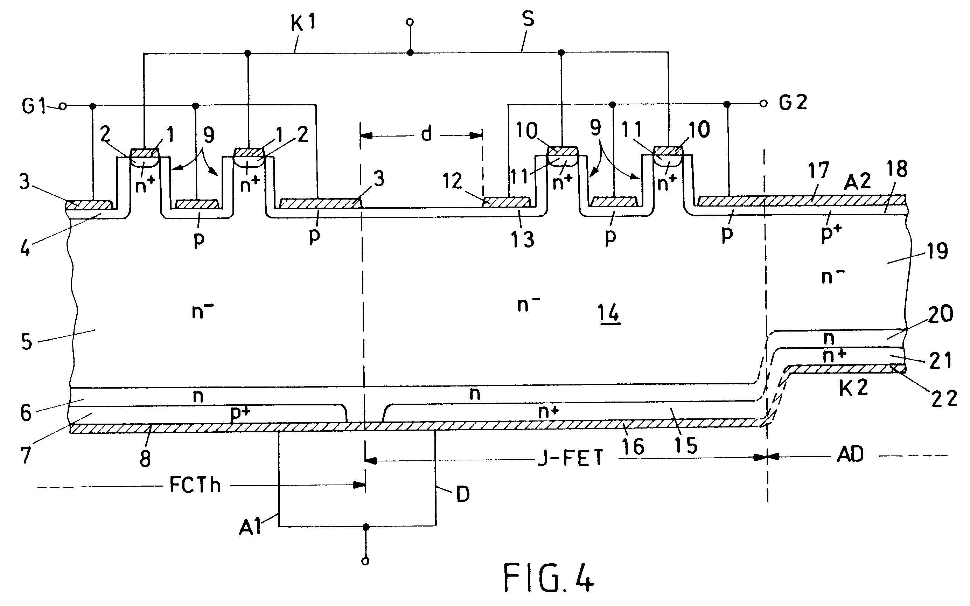

Insbesondere wenn der abschaltbare Thyristor AT ein FCTh ist, kann der steuerbare Widerstand in Form eines J-FET direkt mit dem Thyristor auf einem gemeinsamen Substrat integriert werden, wobei für beide Bauelemente dieselbe Herstellungstechnologie und Geometrie verwendet werden kann (Fig. 4).

In diesem Zusammenhang kann deutlich gemacht werden, warum die erfindungsgemässe Trennung von Sensor- und Ableitfunktion vorteilhaft ist: Prinzipiell könnte in Analogie zu Fig. 1B in das Thyristorsubstrat auch eine Avalanchezone integriert werden, die beide Funktionen in sich vereint.

Eine solche integrierte Avalanchezone müsste, um die Verlustleistung im Bereich mehrerer kW abführen zu können, eine Fläche grösser 5 cm$^2$ aufweisen. Eine derart grosse Fläche erfordert aber eine nicht erreichbare Homogenität der elektrischen Eigenschaften in der Avalanchezone, damit nicht nur wenige Stellen der Zone den gesamten Ableitstrom übernehmen.

Ein erstes Ausführungsbeispiel für eine vollständige Thyristorstufe mit Ansteuerschaltung und Überspannungsschutz ist in Fig. 3A wiedergegeben.

Auf der Ansteuerungsseite ist in dieser Stufe eine Kaskadenschaltung aus dem abschaltbaren Thyristor AT und einem Hilfsthyristor HT vorgesehen. Beide Thyristoren sind FCThs.

Die Ansteuerschaltung umfasst weiterhin einen Kondensator C, einen Vorwiderstand RV1 und eine Spannungsquelle VS. Am Kondensator C liegt eine Gatespannung $V_{G1}$ an; der Hilfsthyristor wird durch ein Eingangssignal $V_{IN}$ angesteuert.

Wenn es sich bei den FCThs um Thyristoren handelt, die bei Kurzschluss zwischen Gate und Kathode leitend sind (sog. "normally-ON"-Bauelemente), fällt die Spannungsquelle VS weg; der Vorwiderstand RV1 liegt dann direkt an der Kathode K1.

Sind die FCThs dagegen vom "normally-OFF"-Typ, hat die Spannungsquelle VS eine Spannung von etwa 5 V.

Einzelheiten über die Funktionsweise einer solchen Thyristorkaskade können der EP-A2 0 246 478 entnommen werden.

Der Überspannungsschutz der Thyristorstufe umfasst den parallelgeschalteten J-FET JF, einen Varistor V (oder eine Avalanchediode AD) als Überspannungssensor, und einen Gatewiderstand RG.

Der Varistor V ist zwischen das Gate G2 und den Drain D des J-FET geschaltet und hat z.B. eine Knickspannung von 4 kV. Der Gatewiderstand RG verbindet das Gate G2 mit dem Gate G1 des abschaltbaren Thyristors AT. Dies hat den speziellen Vorteil, dass eine einfache Integration des Überspannungsschutzes möglich ist.

Der Varistor V in der Schaltung gemäss Fig. 3A trägt trotz des steuerbaren Widerstands immer noch einen relativ hohen Teil der gesamten Verlustleistung und muss daher entsprechend gross gewählt werden.

Um einen kleineren Varistor einsetzen zu können, ist daher in einem zweiten Ausführungsbeispiel (Fig. 3B) zwischen dem Varistor V und dem J-FET eine zusätzliche Verstärkungsstufe vorgesehen, die im Beispiel einen Transistor T und einen zweiten Vorwiderstand RV2 umfasst. Mit einer solchen zusätzlichen Verstärkungsstufe kann der Varistor V wenigstens 10 mal kleiner ausgelegt sein. Der Transistor T wird bei dieser Schaltung im übrigen durch dieselbe Spannungsquelle VS versorgt, wie die Thyristorkaskade HT, AT.

Wie bereits bemerkt, ist es von besonderem Vorteil, als abschaltbaren Thyristor AT einen FCTh zu wählen und gemäss Fig. 4 (ggf. zusammen mit einer Avalanchezone als Überspannungssensor) mit dem J-FET auf einem gemeinsamen Substrat zu integrieren.

Dabei ist zu berücksichtigen, dass ein solcher integrierter J-FET zwar aufgrund seines hohen Widerstandes zum Schalten der Last selbst vollkommen ungeeignet wäre, dass er aber zur Überspannungsbegrenzung leicht richtig dimensioniert werden kann, wie das nachstehende Beispiel für einen FCTh mit 4 kV/1000 A zeigt:

Bei 300 Mikrometer Bulkdicke und 400 Ohm•cm Grundleitfähigkeit des Substrats erreicht man eine Sperrspannung von etwa 4 kV. Das ergibt für einen unipolaren FET einen Widerstand von 12 Ohm bei 1 cm$^2$ Fläche.

Für 1000 A bei 4 kV wären 2,5 Ohm notwendig, die Fläche des FET sollte also mindestens 4,8 cm$^2$ betragen. Daraus folgt eine Stromdichte von 208 A/cm$^2$ und eine Verlustleistung von 8,3•10$^5$ W/cm$^2$ bei 4 kV. Solche Impulsleistungen können im Silizium selbst über Zeiträume von 10 Mikrosekunden beherrscht werden (siehe dazu: A.Nakagawa et al., IEDM 1986, S. 122-125).

Die eingangs angenommenen 2,4 kW Durchschnittsleistung würden eine Verlustleistung von

500 W/cm$^2$ bedeuten, was auch bei sehr guter Kühlung eher an der oberen Grenze liegt. Da ein entsprechender GTO-Thyristor oder FCTh aber ohnehin eine Fläche von wenigstens 20 cm$^2$ nötig hat, kann der J-FET in seiner Fläche ohne Schwierigkeiten etwas vergrössert werden.

Bei dieser Dimensionierung kommt in einer Schaltung gemäss Fig. 3A als Varistor z.B. die Serienschaltung zweier Varistoren vom Typ SIOV-S14K680 und SIOV-S14K1000 der Firma Siemens in Frage. Die Spannung bei 1A ist dann etwa 4 kV, die Kapazität 80 pF.

Bei einer (hoch) angesetzten Anodenspannungssteilheit von 10 kV/Mikrosekunde ergibt dies einen Verschiebungsstrom von 0,8 A. Der Verschiebungsstrom fliesst während des Ausräumens der FCThs, soll also nicht zum Einschalten des J-FET führen. Hinzu kommen etwa 200 pF Gate-Drain-Kapazität vom J-FET entsprechend 2A Verschiebungsstrom. Die Ansprechempfindlichkeit des J-FET muss daher durch den Gatewiderstand RG entsprechend verringert werden.

Mit einer Ansprechschwelle von 4A ergibt sich in den Varistoren bei 2 kHz Wiederholfrequenz und 0,3 Mikrosekunden Belastung pro Periode eine Verlustleistung von 9,6 W, die durch direkte Kühlung leicht abgeführt werden kann.

Die Integration von FCTh und J-FET (und zusätzlich einer Avalanchezone bzw. -diode) soll nun am Ausführungsbeispiel der Fig. 4 erläutert werden, in der ausschnittweise im Querschnitt ein entsprechendes Substrat dargestellt ist.

Das Substrat ist lateral in drei Bereiche unterteilt. Im linken Bereich ist die FCTh-Struktur, im mittleren Bereich die J-FET-Struktur, und im rechten Bereich die Avalanchediodenstruktur (AD) angeordnet.

Die FCTh-Struktur ist vom "recessed gate"-Typ mit einer stufenförmigen Gate-Kathoden-Struktur, die eine Mehrzahl von durch Gräben getrennten Steuerfingern 9 aufweist. Ein solcher FCTh ist z.B. aus der EP-A2 0 178 387 bekannt.

Die FCTh-Struktur umfasst zwischen der Anode A1 und der Kathode K1 eine Schichtenfolge aus einer p$^+$-dotierten Anodenzone 7, einer n$^-$-dotierten Kanalschicht 5, eine p-dotierten Gatezone 4 und n$^+$-dotierten Kathodenbereichen 2.

Die Kathodenbereiche 2 sind auf der Oberseite der Steuerfinger 9 angeordnet. Die Kanalschicht 5 reicht in diese Steuerfinger 9 hinein und grenzt dort an die Kathodenbereiche 2. Die Gatezone 4 erstreckt sich jeweils über die Böden und Wände der Gräben und bildet zusammen mit der im Steuerfinger verlaufenden Kanalschicht 5 einen feldeffektsteuerbaren Langkanal.

Die Gatezone 4 ist auf den Grabenböden mit Gatekontakten 3 versehen, die Kathodenbereiche 2 auf den Steuerfingern 9 mit entsprechenden Kathodenkontakten 1. Anodenseitig stellt ein grossflächiger Anodenkontakt 8 die elektrische Verbindung zu der Anodenzone 7 her.

Die J-FET-Struktur im mittleren Bereich des Substrats ist in Aufbau und Geometrie mit der benachbarten FCTh-Struktur vergleichbar mit dem Unterschied, dass hier eine n$^+$-dotierte Drainzone 15 an die Stelle der p$^+$-dotierten Anodenzone 7 tritt.

Sowohl die Gatezone 4 und die Kathodenbereiche 2 als auch die Kanalschicht 5 und der Anodenkontakt 8 des FCTh setzen sich im J-FET-Bereich unverändert als Gatezone 13, Sourcebereiche 11, Kanalschicht 14 und Drainkontakt 16 des J-FET fort.

Dasselbe gilt für eine zusätzliche n-dotierte Bufferschicht 6, die unterhalb der Kanalschichten 5, 14 verläuft und die Anodenzone 7 und Drainzone 15 untereinander und von diesen Kanalschichten trennt.

Durch die Ausbildung des Anodenkontakts 8 und des Drainkontakts 16 als durchgehende Metallisierungsschicht ist der Drain D des J-FET mit der Anode A1 des FCTh verbunden.

Entsprechend können, wie in Fig. 4 schematisch angedeutet, die Kathodenkontakte 1 und die Sourcekontakte 10 zu einem gemeinsamen Anschluss zusammengeführt werden. Der J-FET liegt dann mit seiner Source S an der Kathode K1 des FCTh.

Anders ist die Situation im Gatebereich: Wie aus Fig. 3A ersichtlich ist, liegt das Gate G2 des J-FET über den Gatewiderstand RG am Gate G1 des FCTh. Dieser Gatewiderstand RG wird zweckmässigerweise dadurch realisiert, dass die an sich auf gleicher Ebene liegenden Gatekontakte 3 und 12 des FCTh bzw. J-FET nicht als durchgehende Metallisierungsschicht ausgeführt sind, sondern zwischen sich eine Lücke mit einem entsprechend gewählten Abstand d aufweisen. Der Teil der Gatezone 4, 13 unter dieser Lücke bildet dann den gewünschten Gatewiderstand RG.

Als Beispiel für einen geeigneten Gatewiderstand seien hier folgende Grössen genannt:
p-Dotierung (4, 13): 1 • 10$^{17}$ cm$^{-3}$
Dicke der Gatezone (4, 13): 10 Mikrometer
Randlänge zwischen FCTh und J-FET: 100 mm
für RG = 5 Ohm ist d = 1,25 mm
Wird anstelle eines externen Varistors V eine Avalanchediode AD als Überspannungssensor vorgesehen, kann diese Diode in Form einer Avalanchezone auch noch in das Substrat integriert werden wie die Fig. 4 (rechter Bereich) zeigt.

Die Diodenstruktur umfasst zwischen Anode A2 und Kathode K2 und den entsprechenden Anoden- bzw. Kathodenkontakten 17 bzw. 22 eine Folge von vier Zonen 18, 19, 20 und 21.

Die erste Zone 18 ist p$^+$-dotiert und eine Fortsetzung der Gatezone 13 des benachbarten J-FET.

Die zweite Zone 19 ist $n^-$-dotiert und eine Fortsetzung der Kanalschicht 14, allerdings mit reduzierter Dicke, um geeignete Durchbruchsspannungen zu erzielen.

Die dritte Zone 20 ist n-dotiert und eine direkte Fortsetzung der Bufferschicht 6.

Die vierte Zone 21 schliesslich ist $n^+$-dotiert und eine direkte Fortsetzung der Drainzone 15.

Sowohl der Anodenkontakt 17 als auch der Kathodenkontakt 22 sind jeweils Fortsetzungen des Gatekontakts 12 bzw. des Drainkontakts 16.

Auf diese Weise wird mit einfachsten Mitteln die gewünschte Verschaltung von FCTh, J-FET und AD gemäss Fig. 3A erreicht.

Insgesamt steht mit dem erfindungsgemässen abschaltbaren Thyristor ein gegen Überspannungen geschütztes Bauelement zur Verfügung, das mit geringem Aufwand realisiert, kompakt aufgebaut und einfach integriert werden kann.

## Patentansprüche

1. Abschaltbarer Thyristor mit Überspannungsschutz, insbesondere für den Einsatz in einer Serieschaltung mehrerer Thyristoren, welcher abschaltbare Thyristor (AT) eine Anode (A1), eine Kathode (K1) und ein Gate (G1) aufweist, dadurch gekennzeichnet, dass
    (a) der Überspannungsschutz einen J-FET (JF) sowie einen Ueberspannungssensor (OS) umfasst; wobei
        (aa) der J-FET (JF) mit seinem Drain (D) an die Anode (A1) und mit seiner Source (S) an die Kathode (K1) des abschaltbaren Thyristors (AT) angeschlossen ist; und
        (bb) der Überspannungssensor (OS) zwischen Drain (D) und Gate (G2) des J-FET (JF) angeordnet ist;
    (b) der abschaltbare Thyristor ein feldgesteuerter Thyristor FCTh ist; und
    (c) der FCTh und der J-FET (JF) auf einem gemeinsamen Substrat nebeneinander integriert sind; wobei
        (aa) der FCTh zwischen der Anode (A1) und der Kathode (K1) eine Schichtenfolge aus einer $p^+$-dotierten Anodenzone (7), einer $n^-$-dotierten Kanalschicht (5), einer p-dotierten Gatezone (4) und $n^+$-dotierten Kathodenbereichen (2) umfasst, wobei die Kathodenbereiche (2) auf der Oberseite von durch Gräben getrennten Steuerfingern (9) angeordnet sind, die Kanalschicht (5) in den Steuerfingern (9) bis zu den Kathodenbereichen (2) reicht, und die Gatezone (4) in die Böden und Wände der Gräben eingelassen ist;

        (bb) der J-FET (JF) zwischen dem Drain (D) und der Source (S) eine Schichtenfolge aus einer $n^+$-dotierten Drainzone (15), einer $n^-$-dotierten Kanalschicht (14), einer p-dotierten Gatezone (13) und $n^+$-dotierten Sourcebereichen (11) umfasst, wobei die Sourcebereiche (11) auf der Oberseite von durch Gräben getrennten Steuerfingern (9) angeordnet sind, die Kanalschicht (14) in den Steuerfingern (9) bis zu den Sourcebereichen (11) reicht, und die Gatezone (13) in die Böden und Wände der Gräben eingelassen ist;
        (cc) beim FCTh über den Kathodenbereichen (2) Kathodenkontakte, auf den Grabenböden Gatekontakte (3), und auf der Anodenzone (7) ein Anodenkontakt (8) angebracht sind; und
        (dd) beim J-FET (JF) über den Sourcebereichen (11) Sourcekontakte (10), auf den Grabenböden Gatekontakte (12), und auf der Drainzone (15) ein Drainkontakt (16) angebracht sind.

2. Abschaltbarer Thyristor nach Anspruch 1, dadurch gekennzeichnet, dass
    (a) die Gatezonen (4, 13) und Kanalschichten (5, 14) des FCTh bzw. J-FET (JF) begrenzte Bereiche einer durch das Substrat verlaufenden, gemeinsamen Gatezone bzw. Kanalschicht sind; und
    (b) der Anodenkontakt (8) des FCTh und der Drainkontakt (16) des J-FET (JF) begrenzte Bereiche einer über das Substrat verlaufenden, gemeinsamen Metallisierungsschicht sind.

3. Abschaltbarer Thyristor nach Anspruch 2, dadurch gekennzeichnet, dass unterhalb der gemeinsam verlaufenden Kanalschicht eine durch das Substrat verlaufende, n-dotierte Bufferschicht (6) angeordnet ist, welche die Anodenzone (8) und die Drainzone (15) untereinander und von der jeweiligen Kanalschicht (5 bzw. 14) trennt.

4. Abschaltbarer Thyristor nach Anspruch 3, dadurch gekennzeichnet, dass
    (a) der Überspannungssensor (OS) eine Avalanchediode (AD) ist; und
    (b) die Avalanchediode (AD) neben dem J-FET (JF) ebenfalls auf dem gemeinsamen Substrat integriert ist; wobei
        (aa) die Avalanchediode (AD) eine Anode (A2) und eine Kathode (K2) sowie anodenseitig einen Anodenkontakt (17) und kathodenseitig einen Kathodenkontakt (22) aufweist;

(bb) zwischen dem Anodenkontakt (17) und dem Kathodenkontakt (22) eine Folge von vier Zonen (18, 19, 20, 21) angeordnet ist;

(cc) die erste Zone (18) $p^+$-dotiert und eine Fortsetzung der gemeinsamen Gatezone, die zweite Zone (19) $n^-$-dotiert und eine Fortsetzung der gemeinsamen Kanalschicht mit reduzierter Dicke, die dritte Zone (20) n-dotiert und eine Fortsetzung der gemeinsamen Bufferschicht (6), und die vierte Zone (21) $n^+$-dotiert und eine Fortsetzung der Drainzone (15) ist; und

(dd) der Anodenkontakt (17) eine Fortsetzung des Gatekontakts (12) des J-FET (JF), und der Kathodenkontakt eine Fortsetzung des Drainkontakts (16) des J-FET (JF) ist.

**Claims**

1. A thyristor with turn-off facility and overvoltage protection, in particular for use in a series circuit of a plurality of thyristors, which thyristor with turn-off facility (AT) has an anode (A1), a cathode (K1) and a gate (G1), characterised in that

(a) the overvoltage protection comprises a J-FET (JF) and an overvoltage sensor (OS);

(aa) the J-FET (JF) being connected by means of its drain (D) to the anode (A1), and by means of its source (S) to the cathode (K1), of the thyristor with turn-off facility (AT);

(bb) the overvoltage sensor (OS) being disposed between drain (D) and gate (G2) of the J-FET (JF);

(b) the thyristor with turn-off facility is a field-controlled thyristor FCTh; and

(c) the FCTh and the J-FET (JF) are integrated adjacently on a common substrate;

(aa) the FCTh comprising, between the anode (A1) and the cathode (K1), a layer sequence composed of a $p^+$-doped anode zone (7), an $n^-$-doped channel layer (5), a p-doped gate zone (4) and $n^+$-doped cathode regions (2), the cathode regions (2) being disposed on the upper side of control fingers (9) separated by trenches, the channel layer (5) extending into the control fingers (9) up to the cathode regions (2), and the gate zone (4) being embedded in the floors and walls of the trenches;

(bb) the J-FET (JF) comprising, between the drain (D) and the source (S), a layer sequence composed of an $n^+$-doped drain zone (15), an $n^-$-doped channel layer (14), a p-doped gate zone (13) and $n^+$-doped source regions (11), the source regions (11) being disposed on the upper side of control fingers (9) separated by trenches, the channel layer (14) extending into the control fingers (9) up to the source regions (11), and the gate zone (13) being embedded in the floors and walls of the trenches;

(cc) in the case of the FCTh, cathode contacts being provided above the cathode regions (2), gate contacts (3) on the trench floors and an anode contact (8) on the anode zone (7); and

(dd) in the case of the J-FET (JF) source contacts (10) being provided above the source regions (11), gate contacts (12) on the trench floors, and a drain contact (16) on the drain zone (15).

2. Thyristor with turn-off facility according to claim 1, characterised in that

(a) the gate zones (4, 13) and channel layers (5, 14) of the FCTh or J-FET (JF) are delineated regions of a common gate zone or channel layer extending through the substrate; and

(b) the anode contact (8) of the FCTh and the drain contact (16) of the J-FET (JF) are delineated regions of a common metallisation layer extending over the substrate.

3. Thyristor with turn-off facility according to Claim 2, characterised in that there is arranged, beneath the commonly extending channel layer, an n-doped buffer layer (6) which extends through the substrate and which separates the anode zone (8) and the drain zone (15) from each other and from the respective channel layer (5 or 14 respectively).

4. Thyristor with turn-off facility according to Claim 3, characterised in that

a) the overvoltage sensor (OS) is an avalanche diode (AD); and

b) the avalanche diode (AD) is also integrated alongside the J-FET (JF) on the common substrate;

aa) the avalanche diode (AD) having an anode (A2) and a cathode (K2) and also an anode contact (17) on the anode side and a cathode contact (22) on the cathode side;

bb) a sequence of four zones (18, 19, 20, 21) being arranged between the anode contact (17) and the cathode contact (22);

cc) the first zone (18) being $p^+$-doped and a continuation of the common gate zone, the second zone (19) being $n^-$-doped and a continuation of the common channel layer with reduced thickness, the third zone (20) being n-doped and a continuation of the common buffer layer (6), and the fourth zone (21) being $n^+$-doped and a continuation of the drain zone (15); and

dd) the anode contact (17) being a continuation of the gate contact (12) of the J-FET (JF), and the cathode contact being a continuation of the drain contact (16) of the J-FET (JF).

**Revendications**

1. Thyristor déclenchable à protection contre les surtensions, destiné en particulier à être utilisé dans un montage en série de plusieurs thyristors, ce thyristor déclenchable (AT) comportant une anode (A1), une cathode (K1) et une gâchette (G1), caractérisé en ce que :

(a) la protection contre les surtensions comprend un J-FET (JF), ainsi qu'un détecteur de surtension (OS);

(aa) le J-FET (JF) est connecté par son drain (D) à l'anode (A1) et par sa source (S) à la cathode (K1) du thyristor déclenchable (AT), et

(bb) le détecteur de surtension (OS) est installé entre le drain (D) et la grille (G2) du J-FET (JF);

(b) le thyristor déclenchable est un thyristor FCTh commandé par le champ, et

(c) le FCTh et le J-FET (JF) sont intégrés l'un à côté de l'autre sur un substrat commun, étant entendu que

(aa) le FCTh comprend, entre l'anode (A1) et la cathode (K1), une succession de couches formée d'une zone d'anode à dopage $p^+$ (7), d'une couche de canal à dopage $n^-$ (5), d'une zone de gâchette à dopage p (4) et de domaines de cathode à dopage $n^+$ (2), les domaines de cathode (2) étant disposés sur la face supérieure de doigts de commande (9) séparés par des fosses, la couche de canal (5) s'étend dans les doigts de commande (9) jusqu'aux domaines de cathode (2), et la zone de gâchette (4) est encastrée dans le fond et les côtés des fosses;

(bb) le J-FET (JF) comprend, entre le drain (D) et la source (S), une succession de couches formée d'une zone de drain à dopage $n^+$ (15), d'une couche de canal à dopage $n^-$ (14), d'une zone de gâchette à dopage p (13) et de domaines de source à dopage $n^+$ (11), les domaines de source (11) étant disposés sur la face supérieure de doigts de commande (9) séparés par des fosses, la couche de canal (14) s'étend dans les doigts de commande (9) jusqu'aux domaines de source (11) et la zone de gâchette (13) est encastrée dans le fond et les flancs des fosses;

(cc) dans le cas du FCTh, sur les domaines de cathode (2) sont prévus des contacts de cathode, sur les fonds des fosses, des contacts de gâchette (3) et sur la zone d'anode (7), un contact d'anode (8), et

(dd) dans le cas du J-FET (JF), sur les domaines de source (11) sont prévus des contacts de source (10), sur les fonds des fosses, des contacts de grille (12) et sur la zone de drain (15), un contact de drain (16).

2. Thyristor déclenchable suivant la revendication 1, caractérisé en ce que :

(a) les zones de gâchette/grille (4, 13) et les couches de canal (5, 14) du FCTh ou J-FET (JF) sont des domaines limités d'une zone de gâchette/grille ou couche de canal commune qui s'étend à travers le substrat, et

(b) le contact d'anode (8) du FCTh et le contact de drain (16) du J-FET (JF) sont des domaines limités d'une couche de métallisation commune s'étendant sur le substrat.

3. Thyristor déclenchable suivant la revendication 2, caractérisé en ce qu'en dessous de la couche de canal commune est disposée une couche tampon (6) à dopage n s'étendant à travers le substrat, qui sépare la zone d'anode (8) et la zone de drain (15) l'une de l'autre et de la couche de canal respective (5 ou 14).

4. Thyristor déclenchable suivant la revendication 3, caractérisé en ce que :

(a) le détecteur de surtension (OS) est une diode à avalanche (AD), et

(b) la diode à avalanche (AD) est intégrée à côté du J-FET (JF) également sur le substrat commun, étant entendu que :

(aa) la diode à avalanche (AD) comporte une anode (A2) et une cathode (K2), ainsi que, du côté de l'anode, un contact d'anode (17) et, du côté de la cathode, un contact de cathode (22);

(bb) entre le contact d'anode (17) et le contact de cathode (22), une succession de quatre zones (18, 19, 20, 21) est prévue;

(cc) la première zone (18) est une zone à dopage $p^+$ et est un prolongement de la zone de grille/gâchette commune, la deuxième zone (19) est une zone à dopage $n^-$ et est un prolongement de la couche de canal commune avec une épaisseur réduite, la troisième zone (20) est une zone à dopage n et est un prolongement de la couche tampon commune (6) et la quatrième zone (21) est une zone à dopage $n^+$ et est un prolongement de la zone de drain (15), et

(dd) le contact d'anode (17) est un prolongement du contact de grille (12) du J-FET (JF) et le contact de cathode est un prolongement du contact de drain (16) du J-FET (JF).

FIG.1A

FIG.1B

FIG.1C

FIG.2

FIG.3A

FIG.3B

FIG.4